# EUROPÄISCHE PATENTSCHRIFT

(11) **EP 2 250 687 B1**
(45) Veröffentlichungstag und Bekanntmachung des Hinweises auf die Patenterteilung: **05.06.2019**
(21) Anmeldenummer: 09717708.3
(22) Anmeldetag: 26.02.2009
(51) Int. Cl.: H01M 2/12, H01M 10/02, H01M 10/04, H01M 10/28, H01M 10/30, H01M 10/34, H01M 10/12

(54) **ENTGASUNGSSYSTEM FÜR EINEN AKKUMULATOR UND AKKUMULATOR MIT EINEM ENTGASUNGSSYSTEM**
DEGASSING SYSTEM FOR AN ACCUMULATOR, AND ACCUMULATOR HAVING A DEGASSING SYSTEM
SYSTÈME DE DÉGAZAGE POUR UN ACCUMULATEUR ET ACCUMULATEUR AVEC SYSTÈME DE DÉGAZAGE

(30) Priorität: 07.03.2008 DE 102008013187
(43) Veröffentlichungstag der Anmeldung: 17.11.2010
(73) Patentinhaber: Johnson Controls Hybrid and Recycling GmbH, 30149 Hannover (DE)
(72) Erfinder: JOSWIG, Ralf, 29690 Buchholz (DE); WIEGMANN, Martin, 27246 Borstel (DE); BRENNER, Helge, 30451 Hannover (DE); KROLL, Edgar, 30823 Garbsen (DE); MÜNSTER, Ralf, 31718 Pollhagen (DE)
(74) Vertreter: Trinks, Ole
(86) Internationale Anmeldenummer: PCT/EP2009/001371
(87) Internationale Veröffentlichungsnummer: WO 2009/109323

(56) Entgegenhaltungen:
- EP-A- 1 298 739
- JP-A- 2005 197 148
- US-A1- 2001 031 390

## Beschreibung

Die Erfindung betrifft ein Entgasungssystem für einen Akkumulator, insbesondere für Hybridakkumulatoren, Nickel Metall-Hydrid-Akkumulatoren und Lithium-Ionen-Akkumulatoren.

Die Erfindung betrifft ferner einen Akkumulator mit einem Entgasungssystem.

Leistungsstarke Akkumulatoren mit hohen Energiedichten in den galvanischen Zellen werden insbesondere in Hybridfahrzeugen und in Elektrofahrzeugen verwendet.

Die hohen Energiedichten führen zu einer hohen Wärmeentwicklung. Um die Leistungsfähigkeit der Akkumulatoren zu erhalten und in einem weiten Betriebsfenster gewährleisten zu können, ist eine effektive Kühlung der Akkumulatoren notwendig. Zudem ist es erforderlich, dass die Akkumulatoren ein Sicherheitssystem aufweisen, das bei einer Überhitzung der Akkumulatoren eingreift, um insbesondere eine Explosion der Zellen zu verhindern.

Neben einer effektiven Kühlung und einem Sicherheitssystem zum Schutz vor einer Überhitzung erfordern leistungsstarke Akkumulatoren ein Sicherheitssystem zum Schutz des Akkumulators vor einem Gasüberdruck in dem Akkumulator. Der Gasüberdruck kann zu plötzlichen Reaktionen und zu einem Entzünden des Akkumulators führen. Dadurch können Menschen und die Umwelt geschädigt werden.

Darüber hinaus ist das Innere der Akkumulatoren vor Staub zu schützen sowie vor Spritzwasser, das beispielsweise durch Hochdruckreiniger oder Dampfstrahler hervorgerufen wird.

Aufgabe der vorliegenden Erfindung ist es, ein Entgasungssystem für einen Akkumulator bereitzustellen, das einerseits das Innere des Akkumulators vor einem Überdruck als auch vor eindringendem Spritzwasser und Staub schützt. Ferner ist es Aufgabe der vorliegenden Erfindung, einen Akkumulator für Hybridfahrzeuge oder Elektrofahrzeuge bereitzustellen, dessen Inneres wirksam vor einem Überdruck als auch vor eindringendem Spritzwasser und Staub geschützt ist.

Die Aufgabe wird erfindungsgemäß durch ein Entgasungssystem mit den Merkmalen von Anspruch 1 sowie einen Akkumulator mit den Merkmalen von Anspruch 10 gelöst.

Das erfindungsgemäße Entgasungssystem schützt einen Akkumulator wirksam vor einem Überdruck im Inneren des Akkumulators. Ein Überdruck kann beispielsweise durch eine Überladung der galvanischen Zellen oder einen Kurzschluss hervorgerufen werden. Wird eine größere Menge Gas aus den galvanischen Zellen in das Akkumulatorgehäuse freigesetzt, wird dieses Gas durch die Membran aus dem Akkumulatorgehäuse abgeführt. Auf diese Weise wird ein Gasüberdruck (Differenz zwischen dem höheren Druck im Akkumulatorinneren und dem Umgebungsdruck) im Akkumulatorinneren wirksam abgebaut. Steigt der Gasdruck im Akkumulator so stark an, dass der Gasüberdruck einen vordefinierten Wert überschreitet, so öffnet die Membran. Das Öffnen kann reversibel (z. B. wieder verschließbares Ventil) oder irreversibel (z. B. Zerreißen der Membran) erfolgen. Zerreißt die Membran, so wird innerhalb kürzester Zeit eine große Menge Gas aus dem Akkumulator abgeführt und somit ein hoher Überdruck abgebaut.

Anstelle einer Membran kann auch ein Siebgeflecht aus Kunststoff mit einer Maschenweite verwendet werden.

Neben dem effektiven Schutz vor einem Überdruck im Akkumulatorinneren verhindert das erfindungsgemäße Entgasungssystem zudem, dass Spritzwasser, Staub oder andere Verunreinigungen von außen in das Akkumulatorinnerer dringen. Dieser Schutz wird dadurch erzielt, dass derartige Verunreinigungen von außen einen mehrfach umgelenkten Weg zurücklegen müssten, um in das Akkumulatorinnere zu gelangen. Das Umlenken bewirkt gleichzeitig einen Schutz der Membran vor äußeren Einflüssen.

Der Schutz vor eindringendem Spritzwasser oder anderen Verunreinigungen kann durch ein zusätzliches Prallblech verbessert werden, das in einem Abstand unterhalb des Labyrinthkorsos angeordnet ist. Auf diese Weise wird zwischen der Unterseite des Labyrinthkorsos und der Oberseite des Prallblechs ein im Wesentlichen horizontal verlaufender Spalt gebildet, der eine zusätzliche Umlenkung des Weges von außen in das Akkumulatorinnere bewirkt.

Der Schutz vor eintretendem Spritzwasser oder anderen Verunreinigungen kann auch dadurch verbessert werden, dass an der Unterseite des Labyrinthkorsos ein Stutzen zum Anschluss eines Schlauches vorgesehen ist, durch das das von Akkumulatorinneren nach außen tretende Gas und gegebenenfalls in dem Akkumulator gebildetes Kondenswasser abgeführt wird.

Um einen unerwünschten Gasaustritt an der Oberseite des Labyrinthkorsos zu vermeiden, ist erfindungsgemäß eine auf dem Labyrinthkorso angeordnete Dichtung vorgesehen. Die Dichtung liegt im Einbauzustand zweckmäßig zwischen der Oberseite des Labyrinthkorsos und dem Boden des Akkumulatorgehäuses. Anstelle oder neben der Dichtung kann auch eine Verschweißung des Entgasungssystems mit dem Akkumulatorgehäuse vorgesehen sein.

Vorzugsweise weist das Entgasungssystem im Wesentlichen kreisförmige Querschnittsflächen auf. Im Wesentlichen kreisförmige Querschnittsflächen ermöglichen eine einfache Herstellung, da sowohl der Labyrinthkorso als auch der Labyrinthbolzen zumindest abschnittsweise die Gestalt eines Hohlzylinders haben. Der innen liegende Hohlraum lässt sich einfach mittels einer Bohrung realisieren.

Je nach Größe des Akkumulators und der auftretenden Energiedichten hat sich als zweckmäßig erwiesen, wenn die Kanäle Querschnittsflächen von 50 mm² bis zu 500 mm² aufweisen, um einen Gasüberdruck im Akkumulatorinneren effektiv abzubauen.

In einer besonderen Ausführungsform ist erfindungsgemäß vorgesehen, dass der Labyrinthbolzen ein Außengewinde und der Labyrinthkorso ein mit dem Außengewinde zusammenwirkendes Innengewinde aufweist. Diese Ausführungsform lässt sich besonders einfach an einem Gehäuseboden eines Akkumulators montieren. Der Gehäuseboden des Akkumulators weist hiezu eine geeignet dimensionierte Öffnung auf. Der Labyrinthkorso wird von der einen Seite (der Außenseite), und der Labyrinthbolzen wird von der anderen Seite (dem Akkumulatorinneren) durch die Öffnung in dem Gehäuseboden geführt. Anschließend werden der Labyrinthkorso und der Labyrinthbolzen miteinander fest verschraubt. Der Gehäuseboden ist dann im eingebauten Zustand fest zwischen dem Labyrinthkorso und dem Labyrinthbolzen eingefasst, ggf. mit einer zusätzlichen Dichtung.

In einer weiteren Ausführungsform weist das Entgasungssystem wenigstens eine partiale Bohrung auf, durch die Komponenten des Entgasungssystems mittels einer Schraubverbindung miteinander verbindbar sind. Diese Ausführungsform ermöglicht die Montage des Entgasungssystems von einer Seite des Gehäusebodens des Akkumulators. Hierzu werden alle Komponenten in der richtigen Reihenfolge von einer Seite an den Gehäuseboden geführt. Der Gehäuseboden weist wenigstens eine korrespondierende Bohrung auf. Durch die wenigstens eine Bohrung durch das Entgasungssystem und durch die wenigstens eine Bohrung in dem Gehäuseboden des Akkumulators wird eine Schraube geführt und auf der anderen Seite des Gehäusebodens mit einer geeigneten Mutter versehen. Vorzugsweise sind mehrere Bohrungen und Schraubverbindungen vorgesehen, etwa drei im Wesentlichen äquidistant um die Öffnung im Gehäuseboden angeordnete Bohrungen.

Neben den vorstehend aufgezeigten Schraubverbindungen ist erfindungsgemäß auch vorgesehen, dass das Entgasungssystem mit dem Gehäuseboden des Akkumulators verschweißt wird. In diesem Fall kann auf die Dichtung verzichtet werden.

Die Erfindung wird in den nachfolgenden Figuren anhand zweier Ausführungsbeispiele je näher werden.

Es zeigen:
- Figur 1: eine perspektivische Ansicht einer ersten Ausführungsform des erfindungsgemäßen Entgasungssystems im eingebauten Zustand,
- Figur 2: einer Schnittansicht der ersten Ausführungsform aus Figur 1,
- Figur 3: eine Explosionsansicht einer zweiten Ausführungsform des erfindungsgemäßen Entgasungssystems,
- Figur 4: eine Seitenansicht der zweiten Ausführungsform im Einbauzustand,
- Figur 5: eine Draufsicht auf die zweite Ausführungsform im Einbauzustand,
- Figur 6: eine Schnittansicht der zweiten Ausführungsform im Einbauzustand
- Figur 7: eine perspektivische Draufsicht der zweiten Ausführungsform im Einbauzustand und
- Figur 8: eine perspektivische Ansicht von unten der zweiten Ausführungsform im Einbauzustand (von unten).

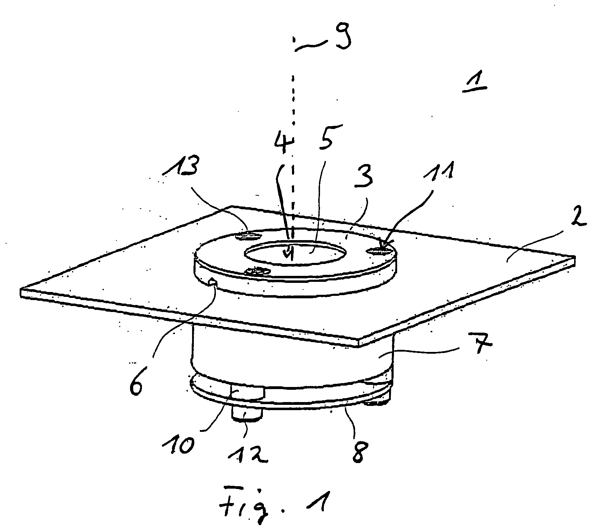

Figur 1 zeigt eine erste Ausführungsform eines erfindungsgemäßen Entgasungssystems 1 im eingebauten Zustand.

Gezeigt ist ein Ausschnitt eines Gehäusebodens 2 eines Akkumulators. In der Figur 1 zeigt die Oberseite des Gehäusebodens 2 zum Akkumulatorinneren und die Seite des Gehäusebodens 2 nach außen, ist also der Umgebung des Akkumulators zugeordnet.

Das Entgasungssystem 1 hat einen im Wesentlichen kreiszylinderförmigen Aufbau. Eine Oberseite 3 eines Labyrinthbolzens ist in das Akkumulatorinnere gerichtet. Die Oberseite 3 des Labyrinthbolzens hat im Wesentlichen die Gestalt eines Hohlzylinders mit einer kreisringförmigen Querschnittsfläche. Die Oberseite 3 des Labyrinthbolzens hat demzufolge eine zentrale kreisförmige Öffnung 4. Die Öffnung 4 ist mit einer Membran 5 verschlossen. Die Oberseite 3 des Labyrinthbolzens hat an seiner Peripherie radial verlaufende Ablaufkanäle 6. Die Ablaufkanäle 6 haben im Wesentlichen einen halbkreisförmigen Querschnitt und dienen dazu, im Akkumulatorinneren sich ansammelndes Kondenswasser bzw. Kondensflüssigkeit abzuführen. In Figur 1 ist ein Ablaufkanal 6 zu erkennen. Insgesamt sind jedoch 3 Ablaufkanäle 6 entlang der Peripherie der Oberseite 3 des Labyrinthbolzens vorgesehen, die äquidistant (also mit einem Winkelabstand von 120°C) zueinander angeordnet sind. Unterhalb des Gehäusebodens ist ein Labyrinthkorso 7 zu erkennen.

Der Labyrinthkorso hat eine zylinderförmige Mantelfläche.

Unterhalb des Labyrinthkorsos 7 ist ein Prallblech 8 angeordnet. Das Prallblech ist in axialer Richtung (in Bezug auf eine Achse 9) unter dem Labyrinthkorso 7 angeordnet. Der über die Querschnittsfläche des Prallblechs 8 konstante Abstand wird durch Abstandshalter 10 gewährleistet. Die Abstandshalter 10 haben die Gestalt von Hohlzylindern.

Die Fixierung des Entgasungssystems 1 an dem Gehäuseboden 2 erfolgt über drei Schraubverbindungen 11. Die Schraubverbindungen sind in konstanten Winkelabständen zueinander angeordnet und weisen jeweils eine Schraube 12 und eine Mutter 13 auf.

Für die Schraubverbindung sind drei paraxiale Bohrungen durch die Komponenten des Entgasungssystems 1 vorgesehen.

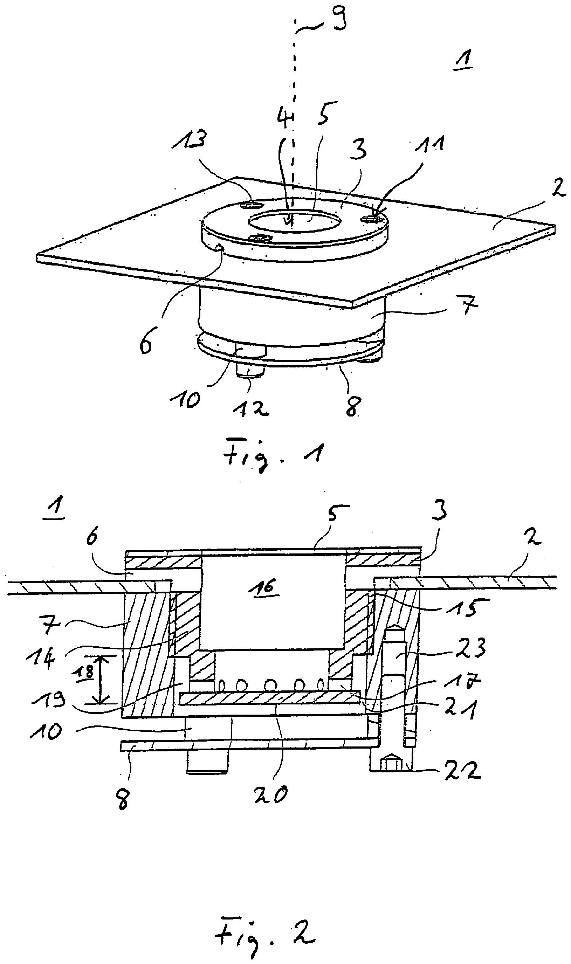

Figur 2 zeigt eine zu der Ausführungsform gemäß der Figur 1 ähnliche Ausführungsform des erfindungsgemäßen Entgasungssystems 1, bei der jedoch die Fixierung des Entgasungssystems 1 an dem Gehäuseboden 2 anders ausgestaltet ist. Entsprechende Komponenten werden mit den gleichen Bezugsziffern wie in Figur 1 versehen.

Statt einer Schraubverbindung sind der Labyrinthkorso 7 und der Labyrinthbolzen 14 über ein zusammenwirkendes Gewinde 15 miteinander lösbar verbunden. Für diese Gewindeverbindung weist der Labyrinthbolzen 14 ein Außengewinde und der Labyrinthkorso 7 ein Innengewinde auf.

Innerhalb des Labyrinthbolzens 14 ist ein Hohlraum 16 gebildet, der über die Membran 5 von dem Akkumulatorinneren in axialer Richtung getrennt ist. Von dem Hohlraum 16 aus erstrecken sich in radialer Richtung (in Bezug auf die Achse 9) Kanäle 17. Es ist eine Mehrzahl von Kanälen 17 vorgesehen.

In einem axialen Abschnitt 18 ist zwischen dem Labyrinthkorso 7 und dem Labyrinthbolzen 14 des im Wesentlichen vertikal ausgerichteten, ringförmig verlaufenden Spalt 19 ausgebildet. In diesen Spalten 19 münden die Kanäle 17. Über die Kanäle 17 und den Spalt 19 gibt es eine gasdurchlässige Verbindung von der Umgebung des Akkumulators über den Hohlraum 16 in das Akkumulatorinnere.

Ein Boden 20 des Labyrinthbolzens 14 erstreckt sich in radialer Richtung etwas weiter nach außen als der darüber liegende Abschnitt, so dass der Spalt 19 in einem unteren Bereich 21 schmaler ausfällt. Hierdurch wird der Schutz vor eindringendem Spritzwasser oder anderen Verunreinigungen verbessert.

Das Prallblech 8 ist in dieser Ausführungsform durch eine Schraube 22 an dem Labyrinthkorso 7 fixiert. Hierzu weist der Labyrinthkorso ein mit einem Gewinde versehenes Loch 23 auf.

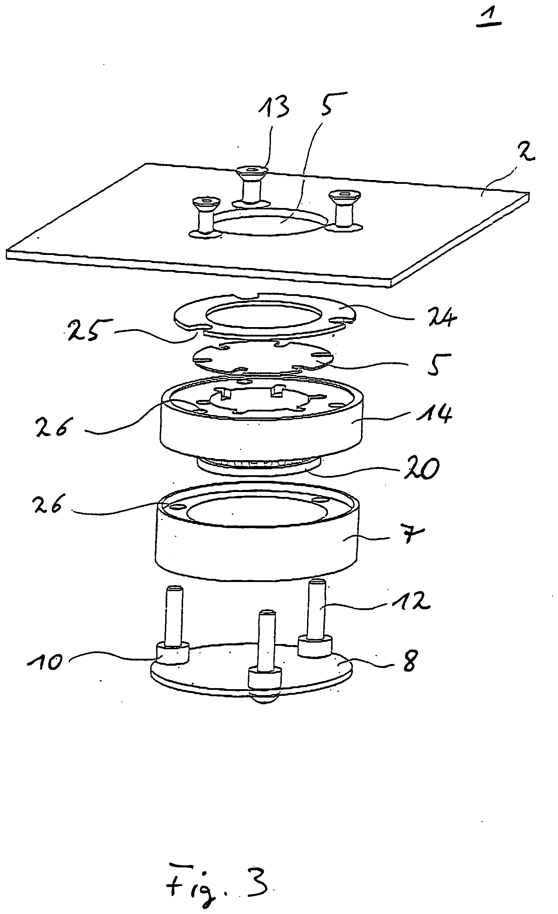

Figur 3 zeigt eine weitere Ausführungsform des erfindungsgemäßen Entgasungssystems 1 in einer Explosionsansicht. Dieses Entgasungssystem wird vollständig von außen (in der Figur von unten) in Bezug auf den Gehäuseboden 2 an dem Gehäuseboden 2 angebracht.

Zwischen dem Gehäuseboden 2 und dem Labyrinthbolzen 14 wird eine Dichtung angeordnet. Die Dichtung 25 hat im Wesentlichen die Form eines Kreisringes. Die Dichtung 25 weist drei sich radial nach innen erstreckende Ausnehmungen 26 auf, durch die die Schrauben 12 bzw. die Muttern 13 teilweise geführt werden.

Zu erkennen sind Bohrungen 26 sowohl durch den Labyrinthkorso 7 als auch durch den Labyrinthbolzen 14. Die Bohrungen 26 (jeweils drei im gleichen Winkelabstand zueinander abgeordnet) dienen dazu, das die Schrauben 12 beim Zusammenbauen hindurchzuführen.

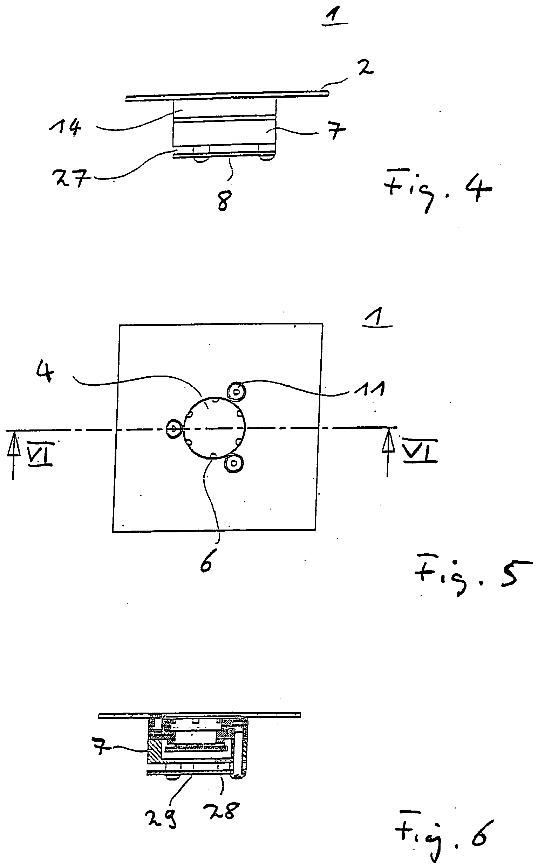

In Figur 4 ist die Ausführungsform aus Figur 3 im Einbauzustand hergestellt.

Zu erkennen ist, dass zwischen dem Prallblech 8 und dem Labyrinthkorso 7 ein im Wesentlichen radial nach außen geführter Spalt 27 ausgebildet ist.

In Figur 5 ist das Entgasungssystem 1 aus Figur 4 in Draufsicht (d. h. vom Akkumulatorinneren aus betrachtet) dargestellt.

Zu erkennen ist die Öffnung 4, die vor der Membran (in der Figur 5 nicht zu erkennen) bedeckt ist.

Ferner sind die drei Schraubverbindungen 11 zu erkennen. Schließlich sind sechs Ablaufkanäle 6 zu erkennen.

Figur 6 zeigt die Ausführungsform aus Figur 5 in einer Schnittansicht in Richtung VI aus Figur 5.

Zu erkennen ist, dass sich ein Boden 28 des Labyrinthkorsos 7 radial ein kleines Stück nach innen erstreckt, wodurch ein Weg von außen nach innen eine zusätzliche Umlenkung erfährt. Der Boden 28 hat eine kreisringförmige Gestalt mit einer Öffnung 29.

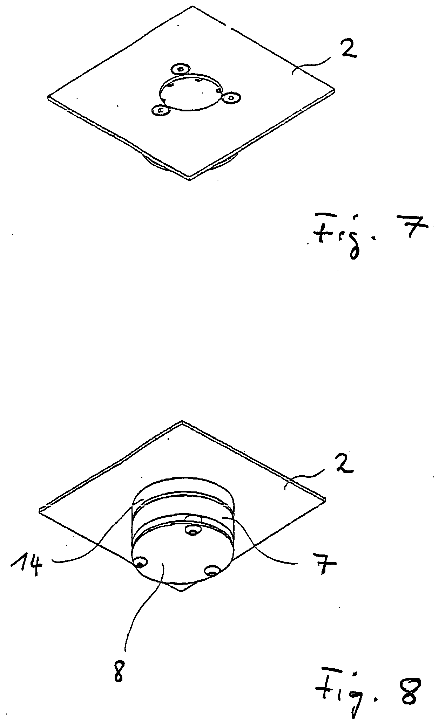

Figur 7 zeigt die Ausführungsform aus Figur 5 in perspektivischer Draufsicht.

Figur 8 zeigt die Ausführungsform aus Figur 7 in perspektivischer Ansicht von unten.

### Bezugszeichenliste

- 1: Entgasungssystem
- 2: Gehäuseboden
- 3: Oberseite eines Labyrinthbolzens
- 4: Öffnung
- 5: Membran
- 6: Ablaufkanäle
- 7: Labyrinthkorso
- 8: Prallblech
- 9: Achse
- 10: Abstandshalter
- 11: Schraubverbindung
- 12: Schraube
- 13: Mutter
- 14: Labyrinthbolzen
- 15: Gewinde
- 16: Hohlraum
- 17: Kanäle
- 18: Axialer Abschnitt
- 19: Spalt
- 20: Boden
- 21: Schmaler Bereich des Spalts 19
- 22: Schraube
- 23: Sackloch
- 24: Dichtung
- 25: Ausnehmung
- 26: Bohrung
- 27: Spalt
- 28: Boden

## Patentansprüche

1. Entgasungssystem für ein Gehäuse eines Akkumulators zum Einsatz in Hybridfahrzeugen und in Elektrofahrzeugen, wobei das Entgasungssystem (1) aufweist:
a) einen Labyrinthbolzen (14) mit einer Bolzenwandung, in der eine Mehrzahl von Kanälen (17) vorgesehen sind, die sich vom Bolzeninneren zu in einem axialen Abschnitt (18) der Bolzenwandung angeordneten Ausgängen hin erstrecken,
b) einen Labyrinthkorso (7) mit einer Korsowandung, die im Einbauzustand derart um den axialen Abschnitt (18) der Bolzenwandung verläuft, dass in dem axialen Abschnitt (18) zwischen der Bolzenwandung und der Korsowandung ein Spalt (19) gebildet ist, und
c) eine gasdurchlässige Membran (5), die an einer zum Akkumulatorinneren gewandten Oberseite des Labyrinthbolzens (14) angeordnet ist.

2. Entgasungssystem nach Anspruch 1,
**gekennzeichnet durch**
ein Prallblech (8), das im Einbauzustand mit Abstand unterhalb des Labyrinthkorsos (7) auf der Außenseite des Akkumulators angeordnet ist.

3. Entgasungssystem nach Anspruch 1 oder 2,
**dadurch gekennzeichnet, dass**
die Membran (5) bei einer vordefinierten Druckdifferenz an der Membran öffnet.

4. Entgasungssystem nach einem der Ansprüche 1 bis 3,
**dadurch gekennzeichnet, dass**
die Membran (5) als offenes Siebgeflecht ausgeführt ist.

5. Entgasungssystem nach einem der Ansprüche 1 bis 4,
**gekennzeichnet durch**
eine Dichtung (24), die im Einbauzustand auf dem Labyrinthbolzen (14) angeordnet ist.

6. Entgasungssystem nach einem der Ansprüche 1 bis 5,
**dadurch gekennzeichnet, dass**
das Entgasungssystem (1) im Wesentlichen kreisförmige Querschnittsflächen aufweist.

7. Entgasungssystem nach einem der vorstehenden Ansprüche,
**dadurch gekennzeichnet, dass**
die Kanäle (17) Querschnittsflächen von 50 mm2 bis 500 mm2 aufweisen.

8. Entgasungssystem nach einem der vorstehenden Ansprüche,
**dadurch gekennzeichnet, dass**
der Labyrinthbolzen (14) ein Außengewinde und der Labyrinthkorso (7) ein mit dem Außengewinde zusammenwirkendes Innengewinde aufweist.

9. Entgasungssystem nach einem der vorstehenden Ansprüche,
**dadurch gekennzeichnet, dass**
die Entgasungssystem wenigstens eine paraxiale Bohrung (26) aufweist, durch die Komponenten der Entgasungssystem (1) mittels einer Schraubeverbindung (11) miteinander verbindbar sind.

10. Akkumulator zum Einsatz in Hybridfahrzeugen und in Elektrofahrzeugen mit wenigstens einem Entgasungssystem (1) nach einem der vorstehenden Ansprüche.

11. Akkumulator nach Anspruch 10,
**dadurch gekennzeichnet, dass**
das wenigstens eine Entgasungssystem (1) in einem Gehäuseboden (2) des Akkumulators vorgesehen ist.

12. Akkumulator nach Anspruch 11,
**dadurch gekennzeichnet, dass**
das wenigstens eine Entgasungssystem (1) mit dem Gehäuseboden (2) verschweißt ist.

13. Akkumulator nach einem der Ansprüche 10 bis 12,
**dadurch gekennzeichnet, dass**
der Labyrinthbolzen (14) vollständig unterhalb des zur Außenseite des Ackumulators gewandten Gehäusebodens (2) oder teilweise oberhalb des Gehäusebodens (2) angeordnet ist.

## Claims

1. Degassing system for a housing of an accumulator for use in hybrid vehicles and in electric vehicles,
wherein the degassing system (1) has:
a) a labyrinth bolt (14) having a bolt wall in which a plurality of channels (17) are provided, which extend from the bolt interior toward outlets which are arranged in an axial section (18) of the bolt wall,
b) a labyrinth corso (7) having a corso wall which, in the installed state, runs around the axial section (18) of the bolt wall such that a gap (19) is formed in the axial section (18) between the bolt wall and the corso wall, and
c) a gas-permeable membrane (5), which is arranged on an upper face, facing the accumulator interior, of the labyrinth bolt (14).

2. Degassing system according to Claim 1,
**characterized by**
a baffle plate (8) which, in the installed state, is arranged at a distance below the labyrinth corso (7) on the outside of the accumulator.

3. Degassing system according to Claim 1 or 2,
**characterized in that**
the membrane (5) opens when there is a predefined pressure difference across the membrane.

4. Degassing system according to one of Claims 1 to 3,
**characterized in that**
the membrane (5) is in the form of an open filter mesh.

5. Degassing system according to one of Claims 1 to 4,
**characterized by**
a seal (24) which, in the installed state, is arranged on the labyrinth bolt (14).

6. Degassing system according to one of Claims 1 to 5,
**characterized in that**
the degassing system (1) has essentially circular cross-sectional areas.

7. Degassing system according to one of the preceding claims,
**characterized in that**
the channels (17) have cross-sectional areas of 50 mm² to 500 mm².

8. Degassing system according to one of the preceding claims,
**characterized in that**
the labyrinth bolt (14) has an external thread, and the labyrinth corso (7) has an internal thread which interacts with the external thread.

9. Degassing system according to one of the preceding claims,
**characterized in that**
the degassing system has at least one hole (26) parallel to the axis, through which components of the degassing system (1) can be connected to one another by means of a screw connection (11).

10. Accumulator for use in hybrid vehicles and in electric vehicles having at least one degassing system (1) according to one of the preceding claims.

11. Accumulator according to Claim 10,
**characterized in that**
the at least one degassing system (1) is provided in a housing base (2) of the accumulator.

12. Accumulator according to Claim 11,
**characterized in that**
the at least one degassing system (1) is welded to the housing base (2).

13. Accumulator according to one of Claims 10 to 12,
**characterized in that**
the labyrinth bolt (14) is arranged completely below the housing base (2), facing the outside of the accumulator, or partially above the housing base (2).

## Revendications

1. Système de dégazage pour un boîtier d'un accumulateur destiné à être utilisé dans les véhicules hybrides et dans les véhicules électriques, le système de dégazage (1) possédant:
a) un goujon à labyrinthe (14) comprenant une paroi de goujon dans laquelle se trouvent une pluralité de canaux (17) qui s'étendent depuis l'intérieur du goujon vers des sorties disposées dans une portion axiale (18) de la paroi de goujon,
b) un logement de labyrinthe (7) comprenant une paroi de logement qui, dans l'état monté, s'étend autour de la portion axiale (18) de la paroi de goujon de telle sorte qu'un interstice (19) est formé dans la portion axiale (18) entre la paroi de goujon et la paroi de logement et
c) une membrane (5) perméable aux gaz qui est disposée au niveau d'un côté supérieur du goujon à labyrinthe (14) faisant face à l'intérieur de l'accumulateur.

2. Système de dégazage selon la revendication 1,
**caractérisé par**
une tôle de chicane (8) qui, dans l'état monté, est disposée avec un écart au-dessous du logement de labyrinthe (7) sur le côté extérieur de l'accumulateur.

3. Système de dégazage selon la revendication 1 ou 2,
**caractérisé en ce que**
la membrane (5) s'ouvre en présence d'une différence de pression prédéfinie au niveau de la membrane.

4. Système de dégazage selon l'une des revendications 1 à 3,
**caractérisé en ce que**
**que** la membrane (5) est réalisée sous la forme d'un treillis de filtrage ouvert.

5. Système de dégazage selon l'une des revendications 1 à 4,
**caractérisé par**
une garniture d'étanchéité (24) qui, dans l'état monté, est disposée sur le goujon à labyrinthe (14).

6. Système de dégazage selon l'une des revendications 1 à 5,
**caractérisé en ce que**
le système de dégazage (1) possède des surfaces transversales sensiblement circulaires.

7. Système de dégazage selon l'une des revendications précédentes,
**caractérisé en ce que**
les canaux (17) possèdent des surfaces transversales de 50 mm² à 500 mm².

8. Système de dégazage selon l'une des revendications précédentes,
**caractérisé en ce que**
le goujon à labyrinthe (14) possède un filetage mâle et le logement de labyrinthe (7) un filetage femelle qui coopère avec le filetage mâle.

9. Système de dégazage selon l'une des revendications précédentes,
**caractérisé en ce que**
le système de dégazage possède au moins un perçage paraxial (26) à travers lequel des composants du système de dégazage (1) peuvent être assemblés entre eux au moyen d'une liaison vissée (11).

10. Accumulateur destiné à être utilisé dans des véhicules hybrides et dans des véhicules électriques, comprenant au moins un système de dégazage (1) selon l'une des revendications précédentes.

11. Accumulateur selon la revendication 10,
**caractérisé en ce que**
l'au moins un système de dégazage (1) se trouve dans un fond de boîtier (2) de l'accumulateur.

12. Accumulateur selon la revendication 11,
**caractérisé en ce que**
l'au moins un système de dégazage (1) est soudé avec le fond de boîtier (2).

13. Accumulateur selon l'une des revendications 10 à 12,
**caractérisé en ce que**
le goujon à labyrinthe (14) est disposé entièrement sous le fond de boîtier (2) orienté vers le côté extérieur de l'accumulateur ou partiellement au-dessus du fond de boîtier (2).
